# EUROPEAN PATENT SPECIFICATION

(11) **EP 1 063 696 B1**
(45) Date of publication and mention of the grant of the patent: **22.08.2007**
(21) Application number: 00870141.9
(22) Date of filing: 22.06.2000
(51) Int. Cl.: H01L 21/768, H01L 21/288

(54) **A method for improving the quality of a metal-containing layer deposited from a plating bath**
Verbesserung der Qualität einer in einem Plattierungsbad abgeschiedenen metallhaltigen Schicht
Procédé d'amélioration de la qualité d'une couche déposée contenant du métal à partir d'un bain de métallisation

(30) Priority: 22.06.1999 US 140484 P; 24.09.1999 EP 99870194
(43) Date of publication of application: 27.12.2000
(73) Proprietor: INTERUNIVERSITAIR MICRO-ELEKTRONICA CENTRUM VZW, 3001 Heverlee (BE)
(72) Inventor: Brongersma, Sywert H., 3000 Leuven (BE); Richard, Emmanuel, 91540 Mennecy (FR); Vervoort, Iwan, 2320 Hoogstraten (BE); Maex, Karen, 3020 Herent (BE)
(74) Representative: pronovem

(56) References cited:
- EP-A- 0 524 818
- EP-A- 0 709 887
- US-A- 3 666 549
- US-A- 4 024 029
- US-A- 4 518 465

## Description

### Field of the invention

The present invention relates to semiconductor processing and more particularly to a method for improving the quality of a metal-containing layer deposited from a plating bath.

### Background of the invention

Currently, copper is being introduced in ULSI metallization schemes as a replacement for aluminum due to its lower resistivity and better electromigration resistance. Copper is used as conductive path. Several techniques for deposition of copper are known, among which electroless copper plating, electrochemical copper plating and copper chemical vapor deposition.

Although Al and SiO₂ are still widely used in interconnect technology, copper and new low-K materials (e.g. polymers) are rapidly being implemented in microelectronics as they are now accepted as the future materials of choice. This major change is necessitated by the ever-decreasing feature sizes that have indicated RC delay-time to be the limiting factor of the next generation of microprocessors. With the use of copper a lower resistance is obtained which, depending on many processing parameters, may be combined with a better resistance to electromigration. At the same time the use of damascene structures has been recently introduced as means of fabricating very narrow structures (less than 0.25 µm). In this scheme narrow trenches or vias are first etched into the low-k material, which are then subsequently filled with Cu. As the depth/width ratio of these structures increases, filling without creating voids or even closing the structure at the top becomes increasingly difficult. Therefore, brighteners and suppressors are added to the plating solution. The terms brighteners and suppressors are known to the person skilled in the art (cf. below). For depositing a copper layer from a copper plating bath, techniques such as electrochemical plating or electroless plating of copper are presently the preferred methods. After depositing the copper layer, a thermal anneal step is usually performed.

However, there are still problems related to the quality of the deposited metal film.

When structures comprising broader openings (like wide trenches and bonding pads or capacitors; typically linewidth higher than 3 µm) and narrower openings (like trenches and vias) need to be filled, hillocks are formed over the narrow openings while the broader openings are filled conformally. This results in the commonly encountered phenomenon of overfilling, resulting in hillocks above the trenches that cause the as-deposited film to locally be as much as twice the normal thickness. This causes severe problems for the subsequent step of chemical-mechanical processing (CMP) which works best on planar films. Apart from CMP, thickness variations of the film is an additional factor that hampers grain-boundary motion.

Although the negative effects on the topography of the deposited copper layer are known, deposition of copper layers from a plating bath is currently the most used technique. Other techniques such as Chemical Vapor Deposition result in less reliable layers and are more expensive.

The deposited copper films by plating can also show a high stress in the layer. They also can by plating exhibit a high sheet resistance.

Another problem that occurs is that the deposited copper layer shows a detrimental adhesion to the underlying layer such as a copper diffusion barrier layer or a dielectric layer.

The above mentioned problems are not limited to the deposition of a copper layer but occur also for other metal layers, for instance a cobalt layer. When a cobalt layer is deposited from a plating bath, the cobalt layer shows the adverse characteristics as mentioned above.

### Aims of the invention

The method of the present invention aims to solve the problems related to the methods for deposition of a metal-containing layer from a plating bath.

It is an aim of the invention to provide a solution to the problems related to the properties of a metal-containing layer deposited from a plating bath in ULSI metallization structures.

### Summary of the present invention

In a first aspect of this invention, a method for depositing a metal-containing film from a metal plating bath on a substrate is described. This method comprises the features of claim 1.

Said step of performing a heating and/or said step of performing a vacuum or said step of depositing said metal-containing layer can be repeated for a number of times in different sequences. Said step of performing a heating step and/or a vacuum step is for removing impurities incorporated in said deposited metal-containing layer and impurities adhered on the surface of said deposited metal-containing layer.

In a first embodiment of the invention, the step of performing a vacuum is executed as an air/vacuum cycle. The air/vacuum cycle is defined as alternately exposing the deposited metal-containing layer to an atmosphere of air or another gas such as N₂, H₂, Ar, He, Kr, NH₃ or any mixture containing one or more of these gasses thereof at atmospheric pressure and exposing the deposited metal-containing layer to an atmosphere of air or another gas such as N₂, H₂, Ar, He, Kr, NH₃ or any mixture thereof or vacuum at a pressure below atmospheric pressure. The pressure below atmospheric pressure is typically but not limited to the range between atmospheric pressure and 10⁻² to 10⁻⁴, 10⁻⁶ and 10⁻⁸ Torr (1 Torr = 133 Pa). Thus a vacuum step is defined as exposing the deposited film to a lower than atmospheric pressure environment.

In an embodiment of this first aspect of the invention, said metal-containing layer can be a copper layer or a cobalt layer.

In a further embodiment of this first aspect of the invention, said metal-containing layer is deposited in at least one narrow opening in a surrounding insulating layer wherein said narrow opening is part of an ULSI metallization structure.

In a further embodiment of this first aspect of the invention, said narrow opening can be a trench, contact hole or via as known in semiconductor processing.

In a further embodiment of this first aspect of the invention, said metal-containing layer is deposited on a metal seed layer. Said metal seed layer can be deposited from a plating bath or by metal PVD. Alternatively, said metal-containing layer is deposited on a barrier layer.

In a further embodiment of this first aspect of the invention, said metal-containing layer is deposited from an electroless plating bath or from an electroplating bath.

Accordingly, a method for depositing a metal-containing film from a metal plating bath on a substrate having at least one opening in an insulating layer is disclosed, comprising the steps :
- depositing a metal-containing layer from said metal plating bath on said substrate in order to have a deposited metal-containing layer in at least one opening,
- performing a heating step and/or a vacuum step on said deposited metal-containing layer,
- depositing a metal-containing layer from said plating bath on said deposited metal-containing layer,
wherein said heating step or vacuum step are performed to eliminate impurities incorporated in the deposited metal-containing layer and impurities adhered on the surface of said deposited metal-containing layer. The quality of the deposited metal-containing layer is improved. Preferably, said step of depositing a metal-containing layer from said plating bath on said substrate is performed until at least one opening is substantially filled with said metal-containing layer.

### Brief description of the drawings

Figure 1 is representing SEM cross-section image of Electrochemically Deposited Cu at various stages of overfill formation to show the situation of Cu deposition according to the state of the art.

Figure 2 is representing SEM cross-section image of ECD Cu using the process according to an embodiment the present invention.

Figure 3 shows that no overfill is present over dense 0.25 µm lines with a 3 step process according to a best mode embodiment of the present invention.

### Detailed description of the invention

According to an aspect of this invention, the problems related to the properties of a metal-containing layer deposited by a plating process on ULSI metallization schemes as mentioned in the background of the invention, can be avoided by eliminating impurities which are present in the metal plating bath and which are adhered to the surface of the substrate. This aspect of method of the invention is not limited to the elimination of impurities in a deposited copper layer but can be valid for a multitude of metal-containing layers which are deposited using a metal plating bath. For the purpose of this invention, impurities can be defined as compounds being present in a plating bath except the metal source molecules (or ions) and compounds which are adhered on the surface of the substrate. The impurities can be additives added to the plating solution to improve the plating of the metal or can be compounds which are accidentally present in the plating bath.

It is known in the art that the bottom-up fill of openings with a high aspect ratio can be obtained through the addition of several organic additives to the plating bath solution. Typical additives are, but are not limited hereto, so-called suppressor and so-called brighteners. A suppressor is known by a person skilled in the art as a surfactant polymer that forms an adsorbed polymeric film on the metal surface such that the free sites are effectively reduced for other bath constituents. Consequently, the growth is suppressed. Typical examples are, but are not limited hereto, polymers formulated from polyethylene glycol (PEG),polypropylene glycol (PPG), and many highly branched derivatives thereof. A brightener (also called accelerator or anti-suppressor) enhances Cu deposition, counteracts the action of the suppressor and reduces metal grain size. Typical examples are, but are not limited hereto organic disulfides, alkylation derivatives of polyethylene imines. Another class of additives are so-called levelers. This class of additives provides a more planar metal-containing layer with less pronounced hillocks.

Typically, additives are organic molecules, organic polymeric molecules and smaller molecules that appear in electrochemical plating baths. These molecules can contain sulfur, carbon, hydrogen or chlorine. Those additives can be incorporated in the deposited metal-containing layer or can be present on the surface of the deposited metal-containing layer. Surprisingly, it was observed that when these materials are incorporated in the metal-containing layer during metal deposition from a plating bath or being present on the surface of the deposited metal-containing layer after deposition from a plating bath, these additives have a negative impact on the quality of the deposited layer. The additives are part of the impurities in or on the surface of the as-deposited film and have a large impact on both the deposition itself, and on subsequent grain growth and processing. The adverse effects of the impurities affect the quality of the deposited metal-containing layer. For example, hillocks can be formed above trenches or via's because the smaller molecules among the additives in the plating bath accumulate in the trenches and via's which have an accelerating effect on grain growth above these structures even after they've been filled completely. Consequently, CMP of the metal film layer is hampered. Other observed problems are: bad adhesion to the layer underlying the metal film, high stress and a high sheet resistance in the deposited metal film.

This can be alleviated through elimination of the impurities. The elimination of the impurities can for instance be done by a thermal anneal step or by exposing the deposited layer to several air/vacuum cycles or both. A thermal anneal step can be performed in a temperature range higher than room temperature. The temperature ranges are typically but not limited to 30-600°C, 50-500°C, 80-400°C, 100-300°C and preferably between 300 and 400°C. The time period for the anneal is typically between 5 s and 10 min, 5 s and 5 min, 10 s and 2 min and preferably between 20 s and 90 s. The anneals can be performed in a Rapid Thermal Processing furnace or in a conventional furnace under an inert gas ambient (N₂, Ar, Kr, He, ...) or a H₂/N₂ ambient or a NH₃ ambient or any other annealing ambient commonly used in semiconductor device processing. The air/vacuum cycle is defined as alternately exposing the deposited metal-containing layer to an atmosphere of air or another gas such as N₂, H₂, Ar, He, Kr, NH₃ or any mixture thereof at atmospheric pressure and exposing the deposited metal-containing layer to an atmosphere of air or another gas such as N₂, H₂, Ar, He, Kr, NH₃ or any mixture thereof or vacuum at a pressure below atmospheric pressure. The pressure below atmospheric pressure is typically but not limited to the range between atmospheric pressure and 10⁻² to 10⁻⁴, 10⁻⁶ and 10⁻⁸ Torr. The elimination of the impurities can also be performed at room temperature in an H₂ ambient.

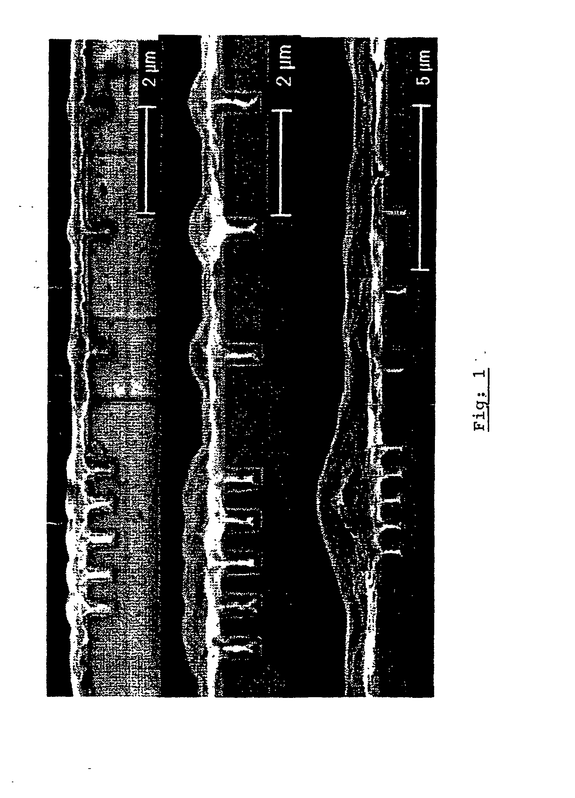

When structures in ULSI metallization schemes need to be filled like structures comprising bonding paths (typically linewidth higher than 5 µm) and structures with a high aspect ratio like trenches and via's, hillocks are formed over the structures with a high aspect ratio, while bonding paths are filled conformally (see Fig. 1). Probably, those hillocks above trenches or via's are formed because the smaller molecules among the additives accumulate in the trenches and vias and on the surface of the deposited metal film. The impurities continue to have an accelerating effect on grain growth above these structures even after they've been filled completely.

In this invention a method is disclosed for depositing a metal-containing film from a metal plating bath on a substrate having at least one opening in an insulating layer. The opening can be, but is not limited hereto a trench, via, contact hole, bonding path or a capacitor. This method comprises the steps of depositing a metal-containing layer from said metal plating bath on said substrate until at least one opening is substantially filled with said metal-containing layer, performing a heating step and/or a vacuum step on said deposited metal-containing layer and depositing another metal, containing layer on said deposited metal containing layer, as defined in claim 1. The steps of performing a heating step and/or vacuum step and/or said step of depositing said second metal-containing layer can subsequently be repeated for a number of times in different sequences until all openings are substantially filled with said metal-containing layer. The heating or vacuum step is performed to eliminate impurities incorporated in the deposited metal-containing layer or impurities present on the surface of the deposited metal-containing layer.

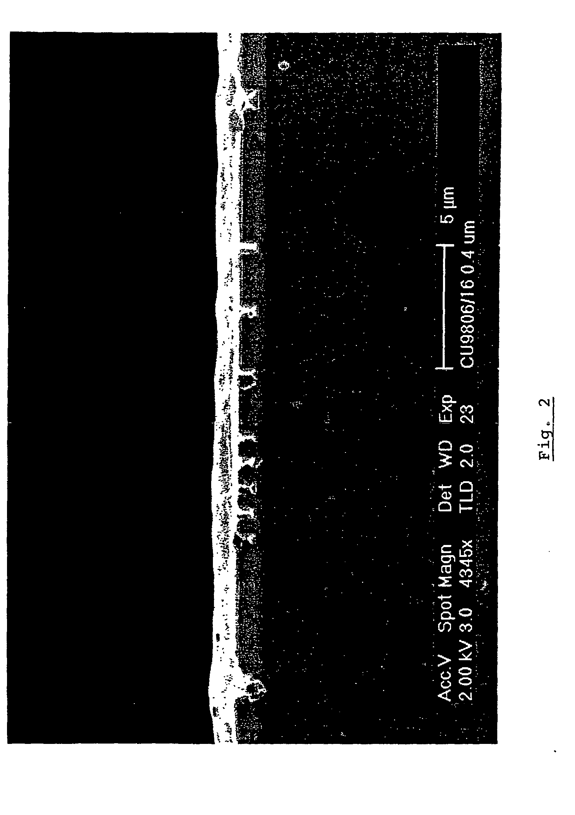

According to an embodiment of the invention, the forming of those hillocks can be avoided by first filling the opening with a metal to a thickness that is sufficient to complete the bottom-up fill of the structures with the highest aspect ratio. Afterwards, the impurities present in or on the first metal-containing layer are eliminated by a thermal anneal step or by exposing the deposited layer to several air/vacuum cycles or both. In a following step, further deposition is performed to a thickness sufficient for planarization. In this way, the forming of hillocks is avoided (see Fig. 2) and CMP can easily be performed.

Another problem that occurs in prior art processing is that the deposited copper films can show a high stress. Exposing the deposited metal-containing layer to a thermal anneal step or several air/vacuum cycles or both will eliminate the impurities and thus reduces the stress.

Finally, the as deposited copper layer according to prior art processing shows a bad adhesion to the underlying layer such as a copper diffusion barrier layer or a dielectric layer. Additives like small molecules containing sulfur, carbon or hydrogen can migrate to the interface of the metal-containing layer and the surrounding layers and consequently reduce the adhesion properties. Elimination of those additives (impurities) by exposing the deposited metal-containing layer to a thermal anneal step or several air/vacuum cycles or both will reduce the adhesion problem.

In a description of a first embodiment of the invention, a Cu barrier layer, a Cu seed layer or another metal-containing layer is deposited in an opening in an insulating layer (step 0). The opening in the insulating layer can be an opening with a high aspect ratio, i.e. an aspect ratio of 1/2 or 1/5 or 1/10. This opening can also be an opening with a linewidth higher than 5 µm, i.e. a bonding path or a capacitor. The copper barrier layer can be Co, Ta, Ti, TiN, TaN, Si₃N₄, WₓN or compounds thereof. The metal-containing layer can be a cobalt layer. In a next step during electrochemical deposition (ECD) of copper (called step 1), deposition proceeds to a thickness that is sufficient to complete the bottom-up fill of the narrow structures.

Thereafter, a further step (step 2) must be included to eliminate local variations in the concentrations of incorporated species and of those adhered to the surface. This may be done by either a thermal anneal or by taking the sample through several air/vacuum cycles (as defined as steps 2a and 2b respectively). This means that the plating should be interrupted. For example, the sample should be taken out of the plating chamber, causing an initial top-down crystallization to occur. The thermal anneal method (step 2a) causes much of the material to be cleaned, but also induces a thermal stress and secondary grain growth.

The air/vacuumcycle (step 2b) removes the unwanted material without causing secondary grain growth, and actually reduces the stress to near-zero values. It is known to reduce concentrations to large depths. Additionally, it may improve adhesion, as the induced diffusion is more one-directional (towards the surface) than for a thermal anneal.

In a next processing step (step 3) the wafer is returned to the ECD-chamber (electro-chemical copper deposition) for further deposition in order to fill large structures to a sufficient thickness for planarization. This is necessary because large structures exhibit conformal filling rather than bottom-up filling. The growth obtained in this step will depend on which of the two possibilities in step 2 is chosen, as one causes large grains and thermal stress in the material (according to step 2a), while grains stay relatively small in the other processing mode (step 2b).

Before going to the CMP step (called step 5), another anneal (step 4) may be included here to obtain large grains that accelerate the CMP process. It would certainly help to stabilize the structure by preventing self-anneal, thereby making the CMP process independent of the timing of the process itself with respect to the deposition. Also, depending on which process was chosen in step 2, the final grain-size in the trenches and vias may depend on whether an anneal is done before or after CMP as nucleation for growth is different before and after the top layer is removed.

A final anneal (step 6) may be needed in order to stabilize/optimize the grain-structure.

In a description of a second embodiment of the invention, a Cu barrier layer, a Cu seed layer or another metal-containing layer is deposited in an opening in an insulating layer using a metal plating bath (step 0). The opening in the insulating layer can be an opening with a high aspect ratio, i.e. an aspect ratio of 1/2 or 1/5 or 1/10. This opening can also be an opening with a linewidth higher than 5 µm, i.e. a bonding path or a capacity. The copper barrier layer can be based on Co, Ta, and Ti. The metal-containing layer can be a cobalt layer. One of the group of the Cu barrier layer, Cu seed layer or another metal-containing layer is deposited on the opening in the insulating layer and do not completely fill the opening (step 1).

A further step must be included to eliminate local variations in the concentrations of incorporated species (impurities) and of those adhered to the plated surface. This may be done by either a thermal anneal or by taking the sample through several air/vacuum cycles (respectively defined as step 2a and 2b). This means that the plating should be interrupted. For example, the sample must be taken out of the chamber, causing an initial top-down crystallization to occur.

In a following step (defined as step 3), deposition of copper from a plating bath proceeds to a thickness that is sufficient to complete the bottom-up fill of the narrow structures.

Again, a further step (step 4) can be included to eliminate local variations in the concentrations of incorporated species and of those adhered to the surface. This may be done by either a thermal anneal or by taking the sample through several air/vacuum cycles (respectively defined as step 4a and 4b). For both choices the sample must be taken out of the chamber, causing an initial top-down crystallization to occur. The first processing mode (step 4a) causes much of the material to be cleaned, but also induces a thermal stress and secondary grain growth. The second processing mode (step 4b) removes the unwanted material without causing secondary grain growth, and actually reduces the stress to near-zero values. It is known to reduce concentrations to large depths. Additionally, it may improve adhesion, as the induced diffusion is more one-directional (towards the surface) than for a thermal anneal.

Thereafter the wafer is returned to the ECD-chamber for further deposition (defined as step 5) in order to fill large structures to a sufficient thickness for planarization. This is necessary because large structures exhibit conformal filling rather than bottom-up filling. The growth obtained in this step will depend on which of the two possibilities in steps 2 and 4 was chosen, as one causes large grains and thermal stress in the material (step 2a, 4a), while grains stay relatively small in the other (step 2b, 4b).

Before going to the CMP step, another anneal (step 4bis) may be included here to obtain large grains that accelerate the CMP process. It would certainly help to stabilize the structure by preventing self-anneal, thereby making the CMP process independent of the timing of the process itself with respect to the deposition. Also, depending on which process mode was chosen in step 2 or 4, the final grain-size in the trenches and vias may depend on whether an anneal is done before or after CMP as nucleation for growth is different before and after the top layer is removed.

A final anneal may be needed in order to stabilize/optimize the grain-structure (step 6).

### Description of the best mode embodiment

Experiments were performed on 6 and 8 inch silicon wafers using a commercially available copper sulfate based plating bath and organic additives developed for IC filling and commercially available from Shipley. Wafers received a TaN barrier layer and a Cu seed layer that are plasma sputtered on dielectric patterned substrates. Two kinds of organic additives are used: one called "brightener" and an other one called "suppressor", as commercially provided by the company Shipley. Suppressor concentration is kept constant. The analysis of those additives in the plating bath is based on Cyclic Voltametric Stripping technique. The copper ECD layers are deposited using a Semitool Equinox^{®} fountain plater. A high-resolution profilometer HRP220 from KLA is used to measure surface topography of the Cu ECD layer deposited overlying patterned dies. Structures with various widths of lines are chosen for this evaluation. For focussed ion beam (FIB) imaging and SEM pictures, a FEI200 and Philips XL30 are used respectively. Typical resulting structures are shown in Figure 2.

The sequence that was used for the best mode embodiment consists in inserting an anneal treatment after filling trench to get the same surface grain size and help desorption. This sequence maintains a void-free deposit and limits the increasing step-height undesirable for the CMP process.

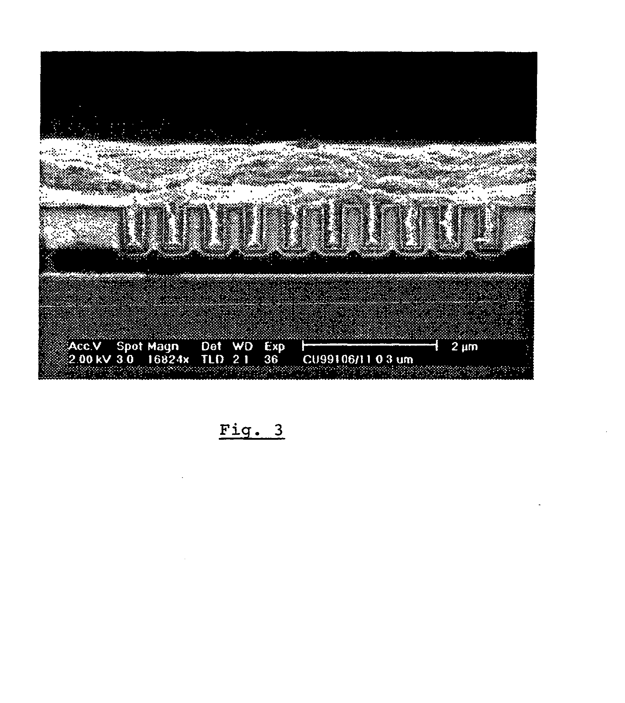

Fig. 3 displays the copper layer overlying dense trench structure according to the best mode processing. A 3-step approach was used as route. It clearly indicates that no "overfill" is observed anymore. The processing sequence that was used in detail is as follows :
- step 1: electrochemical deposition of Cu,
- step 2: interruption of the deposition process and annealing at 120°C in a conventional furnace under a nitrogen (N2) ambient,
- step 3: further filling of the opening by electrochemical deposition.

## Claims

1. Method for depositing a metal-containing film from a metal-plating bath on a substrate having at least one opening in an insulating layer, comprising at least the steps of :
- depositing a metal-containing layer from said metal plating bath on said substrate in order to have a deposited metal-containing layer in at least one opening,
- performing a heating step and/or a vacuum exposure step on said deposited metal containing layer,
- depositing another metal-containing layer from said metal plating bath on said deposited metal-containing layer
wherein said step of performing a heating and/or said step of performing a vacuum exposure are carried out in order to obtain the elimination of impurities incorporated in said deposited metal-containing layer or of impurities adhered to the surface of said deposited metal-containing layer.

2. The method as recited in claim 1 further comprising, in order to fill said opening, the step of further repeating in any sequence at least one of the steps of depositing a metal-containing layer, of performing a heating and/or of performing a vacuum exposure for a number of times, until to obtain that all the openings in the insulating layer are substantially filled with said deposited metal-containing layer.

3. The method as recited in anyone of the preceding claims wherein the metal-containing layer is a copper layer or a cobalt layer.

4. The method as recited in anyone of the preceding claims wherein the step of performing a vacuum exposure is executed by exposing the deposited metal-containing layer to an air/vacuum-cycle by alternately exposing the deposited metal-containing layer to an atmosphere of air or another gas such as N₂, H₂, Ar, He, Kr, NH₃ or any mixture containing one or more of these gasses, at atmospheric pressure and exposing the deposited metal-containing layer to an atmosphere of air or another gas such as N₂, H₂, Ar, He, Kr, NH₃ or any mixture thereof or vacuum at a pressure below atmospheric pressure.

5. The method as recited in anyone of the preceding claims wherein said opening is a narrow opening in an insulating layer which is part of an ULSI metallization structure.

6. The method as recited in claim 5 wherein said narrow opening belongs to the group of a trench, a contact hole or a via in said ULSI metallization structure.

7. The method as recited in anyone of the preceding claims wherein prior to the step of depositing a metal-containing layer from said metal-plating bath on said substrate, a step of depositing a metal-containing seed layer is performed.

8. The method as recited in anyone of the preceding claims wherein said metal plating bath is an electroless metal-containing plating bath or an electrolytic metal-containing plating bath.

## Patentansprüche

1. Verfahren für die Auftragung eines metallhaltigen Überzugs von einem Metallplattierungsbad auf einem Substrat, das mindestens eine Öffnung in einer Isolierungsschicht aufweist, welches mindestens folgende Schritte umfasst:
- Auftragen einer metallhaltigen Schicht von dem Metallplattierungsbad auf dem Substrat, um eine aufgetragene metallhaltige Schicht in mindestens einer Öffnung aufzuweisen,
- Durchführen eines Erwärmungsschritts und/oder eines Vakuumeinwirkungsschritts an der aufgetragenen metallhaltigen Schicht,
- Auftragen einer weiteren metallhaltigen Schicht von dem Metallplattierungsbad auf der aufgetragenen metallhaltigen Schicht,
wobei der Schritt des Durchführens einer Erwärmung und/oder der Schritt des Durchführens einer Vakuumeinwirkung ausgeführt werden, um die Beseitigung von Verunreinigungen, die in der aufgetragenen metallhaltigen Schicht inkorporiert sind, oder von Verunreinigungen; welche an der Oberfläche der aufgetragenen metallhaltigen Schicht anhaften, zu erreichen.

2. Verfahren nach Anspruch 1, welches ferner, um die Öffnung zu füllen, den Schritt des erneuten Wiederholens in irgendeiner Abfolge von mindestens einem der Schritte des Auftragens einer metallhaltigen Schicht, des Durchführens einer Erwärmung und/oder Durchführens einer Vakuumeinwirkung einige Male, umfasst, bis zum erreichen, dass alle Öffnungen in der Isolierungsschicht im Wesentlichen mit der aufgetragenen metallhaltigen Schicht gefüllt sind.

3. Verfahren gemäß irgendeinem der vorangehenden Ansprüche, wobei die metallhaltige Schicht eine Kupferschicht oder eine Kobaltschicht ist.

4. Verfahren gemäß irgendeinem der vorangehenden Ansprüche, wobei der Schritt des Durchführens einer Vakuumeinwirkung ausgeführt wird, indem die aufgetragene metallhaltige Schicht einem Luft/Vakuumzyklus ausgesetzt wird, indem man die aufgetragene metallhaltige Schicht einer Atmosphäre von Luft oder einem anderen Gas, wie zum Beispiel N₂, H₂, Ar, He, Kr, NH₃ oder einer beliebigen Mischung, welche eines oder mehrere dieser Gase enthält, bei atmosphärischem Druck aussetzt, und indem man die aufgetragene metallhaltige Schicht einer Atmosphäre von Luft oder einem anderen Gas, wie zum Beispiel N₂, H₂, Ar, He, Kr, NH₃ oder einer beliebigen Mischung aus diesen oder einem Vakuum bei einem Druck unter atmosphärischem Druck aussetzt.

5. Verfahren nach irgendeinem der vorangehenden Ansprüche, wobei die Öffnung eine schmale Öffnung in einer Isolierungsschicht, welche Teil einer ULSI-Metallisierungsstruktur ist, ist.

6. Verfahren nach Anspruch 5, wobei die schmale Öffnung der Gruppe einer Furche, eines Kontaktlochs oder einer Bohrung in der ULSI Metallisierungsstruktur angehört.

7. Verfahren nach irgendeinem der vorangehenden Ansprüche, wobei vor dem Schritt des Auftragens einer metallhaltigen Schicht von dem Metallplattierungsbad auf dem Substrat ein Schritt des Auftragens einer metallhaltigen Impfschicht durchgeführt wird.

8. Verfahren nach irgendeinem der vorangehenden Ansprüche, wobei das Metallplattierungsbad ein stromloses metallhaltiges Plattierungsbad oder ein elektrolytisches metallhaltiges Plattierungsbad ist.

## Revendications

1. Procédé pour déposer un film contenant du métal à partir d'un bain de métallisation sur un substrat ayant au moins une ouverture dans une couche isolante, comprenant au moins les étapes consistant à :
- déposer une couche contenant du métal à partir dudit bain de métallisation sur ledit substrat, pour obtenir une couche déposée contenant du métal, dans au moins une ouverture,
- procéder à une étape de chauffage et/ou à une étape d'exposition à un vide sur ladite couche déposée contenant du métal,
- déposer une autre couche contenant du métal à partir dudit bain de métallisation sur ladite couche déposée contenant du métal,
dans lequel ladite étape de chauffage et/ou ladite étape d'exposition à un vide sont effectuées en vue d'obtenir l'élimination d'impuretés incorporées à ladite couche déposée contenant du métal ou d'impuretés collées à la surface de ladite couche déposée contenant du métal.

2. Procédé selon la revendication 1, comprenant également, dans le but de remplir ladite ouverture, l'étape consistant à répéter encore, selon une séquence quelconque, au moins l'une des étapes visant à déposer une couche contenant du métal, à procéder au chauffage et/ou à procéder à une exposition à un vide, un certain nombre de fois jusqu'à ce que toutes les ouvertures de la couche isolante soient substantiellement remplies de ladite couche déposée contenant du métal.

3. Procédé selon l'une quelconque des revendications précédentes, dans lequel la couche contenant du métal est une couche de cuivre ou une couche de cobalt.

4. Procédé selon l'une quelconque des revendications précédentes, dans lequel l'étape consistant à procéder à une exposition à un vide est réalisée en exposant la couche déposée contenant du métal à un cycle air/vide en exposant alternativement la couche déposée contenant du métal à une atmosphère d'air ou d'un autre gaz, tel que N₂, H₂, Ar, He, Kr, NH₃ ou à n'importe quel mélange contenant un ou plusieurs de ces gaz, à pression atmosphérique, et en exposant la couche déposée contenant du métal à une atmosphère d'air ou d'un autre gaz, tel que N₂, H₂, Ar, He, Kr, NH₃ ou à n'importe quel mélange de ceux-ci ou à un vide, à une pression inférieure à la pression atmosphérique.

5. Procédé selon l'une quelconque des revendications précédentes, dans lequel ladite ouverture est une ouverture étroite dans une couche isolante qui fait partie d'une structure de métallisation de type ULSI.

6. Procédé selon la revendication 5, dans lequel ladite ouverture étroite appartient au groupe constitué d'une tranchée, d'une ouverture de contact ou d'un trou d'interconnexion dans ladite structure de métallisation de type ULSI.

7. Procédé selon l'une quelconque des revendications précédentes, dans lequel on procède, avant l'étape consistant à déposer une couche contenant du métal à partir dudit bain de métallisation sur ledit substrat, à une étape consistant à déposer une couche d'ensemencement contenant du métal.

8. Procédé selon l'une quelconque des revendications précédentes, dans lequel ledit bain de métallisation est un bain de métallisation auto-catalytique contenant du métal, ou un bain de métallisation électrolytique contenant du métal.
